# EUROPEAN PATENT APPLICATION

(11) **EP 4 796 379 A1**
(43) Date of publication of application: **26.08.2026**
(21) Application number: 24921275.4
(22) Date of filing: 18.06.2024
(51) Int. Cl.: B60L 58/10, B60L 3/00

(54) **METHOD AND APPARATUS FOR CONTROLLING BATTERY**

(30) Priority: 02.02.2024 CN 202410150478
(71) Applicant: Contemporary Amperex Technology Co., Limited, Ningde, Fujian 352100 (CN)
(72) Inventor: WU, Kai, Ningde, Fujian 352100 (CN); SHEN, Dan, Ningde, Fujian 352100 (CN); WU, Shaoji, Ningde, Fujian 352100 (CN); LI, Yao, Ningde, Fujian 352100 (CN); CHEN, Shilong, Ningde, Fujian 352100 (CN); SHI, Junchao, Ningde, Fujian 352100 (CN)
(74) Representative: Kraus & Lederer PartGmbB
(86) International application number: PCT/CN2024/099898
(87) International publication number: WO 2025/161238

(57) **Abstract**

Embodiments of the present application provide a method and apparatus for controlling a battery, which can improve the reliability of supplying power to an electrical device by the battery. The method for controlling a battery is applicable to a battery management system, and comprises: sending first state information, the first state information being used for indicating that a battery is in a first abnormal state; and receiving first control information, the first control information being determined by the first state information, and the first control information being used for instructing the battery management system to control the battery to be in a closed state in a first time period.

## Description

### CROSS-REFERENCE TO RELATED APPLICATIONS

The present application claims priority to Chinese Patent Application No. 202410150478.6 filed on February 2, 2024, entitled "METHOD AND APPARATUS FOR CONTROLLING BATTERY", which is incorporated herein by reference in its entirety.

### TECHNICAL FIELD

Embodiments of the present application relate to the field of batteries, and more specifically, to a method and apparatus for controlling a battery.

### BACKGROUND

With the rapid development of electric vehicle technology, electric vehicles have become an important part of the sustainable development of the automotive industry due to their energy-saving and environmentally friendly advantages. For electric vehicles, battery technology is an important factor related to their development.

With the development of battery technology, various performances of batteries are continuously improving. In the process of a battery supplying electric energy to an electric device, the reliability of the battery in delivering electrochemical performance is an important factor for evaluating battery quality. Therefore, how to improve the reliability of the battery remains a problem to be solved.

### SUMMARY

Embodiments of the present application provide a method and apparatus for controlling a battery, so as to improve the reliability of the battery supplying power to an electric device.

According to a first aspect, a method for controlling a battery is provided, applied to a battery management system, and includes: sending first state information, where the first state information is configured to indicate that the battery is in a first abnormal state; and receiving first control information, where the first control information is determined based on the first state information and configured to instruct a battery management system to control the battery to be in a closed state within a first time period.

In the embodiments of the present application, the battery management system may receive instructions from a battery system controller when the battery is in an abnormal state and control the battery to be in a closed state within a certain time period after a battery fault occurs, thereby supplying power to the vehicle. This allows the vehicle to maintain sufficient power to stop, reducing the possibility of accidents caused by the vehicle losing power due to sudden battery power failure. Moreover, the BMS controlling the battery to continuously supply power to the vehicle facilitates continuous cooling of the battery by thermal management components, inhibits heat diffusion inside the battery, reduces the possibility of further damage to the battery, and allows the battery state of charge to decrease, facilitating subsequent maintenance or replacement of the battery. Continuous power supply from the battery to the vehicle may also extend the duration of acoustic, optical, and electrical alarms of the vehicle, providing assistance to the user. Overall, the embodiments of the present application may improve battery reliability, reduce the risk of severe accidents, and enhance the user experience.

In some embodiments, the method further includes: receiving second control information, where the second control information is configured to instruct the battery management system to control the battery to be in an open state within a second time period and to be closed at the end of the second time period, where a start time of the second time period is the same as an end time of the first time period.

The battery being in an open state within the second time period enables timely disconnection of the electrical connection between the vehicle and the battery once the vehicle has stopped, thereby reducing the high-voltage risk caused by continuous energization.

In some embodiments, the method further includes: sending second state information of the battery, where the second state information is configured to indicate that the battery is in a second abnormal state after the end of the first time period.

The battery management system, by sending the second state information of the battery, may determine the second control information based on the actual state of the battery, and more flexibly and accurately control the battery state. This facilitates rapid reduction of risks posed by the battery in an abnormal state and improves the reliability of the battery in supplying power to the vehicle.

In some embodiments, the first control information is further configured to instruct the battery to be in an open state within a third time period and to be closed at the end of the third time period, where an end time of the third time period is the same as a start time of the first time period.

Considering that an abnormality occurring when the battery is in a closed state is prone to causing a high-voltage risk, in the method provided in the embodiments of the present application, the abnormal battery is controlled to immediately enter an open state, thereby reducing the possibility of the abnormal battery causing a high-voltage risk. Moreover, controlling the battery to return to the closed state after the third time period allows electric energy to be supplied to the vehicle in a timely manner, reducing the risk of accidents caused by the vehicle losing power and facilitating thermal management components in regulating the battery temperature.

In some embodiments, the start time of the first time period is the same as a time at which the battery management system receives the first control information.

This enables the state of the battery to be controlled in a timely manner when an abnormality occurs in the battery, reducing the possibility of the battery being forcibly powered off in an abnormal state and thereby reducing the possibility of accidents caused by the vehicle suddenly losing power.

In some embodiments, the receiving first control information includes: receiving the first control information when the battery is in the closed state.

The battery management system may controll the battery in a closed state, reducing the possibility of accidents caused by the battery in an abnormal state.

In some embodiments, the method further includes: sending wake-up information when the battery is in an open state, where the wake-up information is configured to instruct a battery system controller to switch from a non-working state to a working state.

When the vehicle is in a parked state, the battery management system wakes up the battery system controller, so that abnormalities that have occurred or are about to occur in the battery may be controlled in a timely manner, thereby reducing adverse effects of the abnormal state of the battery on the vehicle and reducing the possibility of accidents caused by the battery in the abnormal state.

In some embodiments, the sending first state information includes: sending the first state information when the battery system controller is in a working state.

This enables the battery to be jointly controlled with the battery system controller when the battery system controller is in a working state, and reduces power consumption of the battery system controller when the battery system controller is not required.

In some embodiments, the method further includes: acquiring battery parameters of the battery; and determining the first state information based on the battery parameters.

Battery parameters may often directly reflect the state of the battery, and the battery management system may acquire the state of the battery more quickly and directly based on the battery parameters, which is beneficial for improving the speed and accuracy of acquiring the battery state.

In some embodiments, the battery parameters include at least one parameter among voltage, current, air pressure, temperature, and gas concentration of the battery.

These parameters may more intuitively reflect whether the battery is in an abnormal state, and utilizing these parameters is beneficial for improving the accuracy of the battery management system in determining the battery state.

According to a second aspect, a method for controlling a battery is provided, applied to a battery system controller, and includes: acquiring first state information, wherein the first state information is configured to indicate that the battery is in a first abnormal state; and determining first control information based on the first state information, where the first control information is configured to instruct a battery management system to control the battery to be in a closed state within a first time period.

In the embodiments of the present application, the battery system controller may instruct the battery management system to supply power to the vehicle within a certain time period after a battery fault occurs. This allows the vehicle to maintain sufficient power to stop, reducing the possibility of accidents caused by the vehicle losing power due to sudden battery power failure. Moreover, continuously supplying power from the battery to the vehicle facilitates continuous cooling of the battery by thermal management components, inhibits heat diffusion inside the battery, reduces the possibility of further damage to the battery, and allows the battery state of charge to decrease, facilitating subsequent maintenance or replacement of the battery. Continuous power supply from the battery to the vehicle may also extend the duration of acoustic, optical, and electrical alarms of the vehicle, providing assistance to the user. Overall, the embodiments of the present application may improve battery reliability, reduce the risk of severe accidents, and enhance the user experience.

In some embodiments, the method further includes: sending second control information, where the second control information is configured to instruct the battery management system to control the battery to be in an open state within a second time period and to be closed at the end of the second time period, where a start time of the second time period is the same as an end time of the first time period.

The battery being in an open state within the second time period enables timely disconnection of the electrical connection between the vehicle and the battery once the vehicle has stopped, thereby reducing the high-voltage risk caused by continuous energization.

In some embodiments, the sending second control information includes: acquiring second state information of the battery, where the second state information is configured to indicate that the battery is in a second abnormal state after the end of the first time period; and sending the second control information based on the second state information.

The battery system controller, by acquiring the second state information of the battery, may determine the second control information based on the actual state of the battery. This allows more flexible and accurate control of the battery, facilitating rapid reduction of risks posed by the battery in an abnormal state and improves the reliability of the battery in supplying power to the vehicle.

In some embodiments, the first control information is further configured to instruct the battery to be in an open state within a third time period and to be closed at the end of the third time period, where an end time of the third time period is the same as a start time of the first time period.

Considering that an abnormality occurring when the battery is in a closed state is prone to causing a high-voltage risk, in the method provided in the embodiments of the present application, the abnormal battery is controlled to immediately enter an open state, thereby reducing the possibility of the abnormal battery causing a high-voltage risk. Moreover, controlling the battery to return to the closed state after the third time period allows electric energy to be supplied to the vehicle in a timely manner, reducing the risk of accidents caused by the vehicle losing power and facilitating thermal management components in regulating the battery temperature.

In some embodiments, the start time of the first time period is the same as a time at which the battery management system receives the first control information.

This enables the state of the battery to be controlled in a timely manner when an abnormality occurs in the battery, reducing the possibility of the battery being forcibly powered off in an abnormal state and thereby reducing the possibility of accidents caused by the vehicle suddenly losing power.

In some embodiments, the method further includes: sending the first control information when the battery system controller is in a working state.

This may reduce power consumption of the battery system controller when the vehicle is not in use.

In some embodiments, the method further includes: receiving wake-up information, where the wake-up information is configured to instruct the battery system controller to switch from a non-working state to a working state.

When the vehicle is in a parked state, the battery management system wakes up the battery system controller, so that abnormalities that have occurred or are about to occur in the battery may be controlled in a timely manner, thereby reducing adverse effects of the abnormal state of the battery on the vehicle and reducing the possibility of accidents caused by the battery in the abnormal state.

In some embodiments, the acquiring first state information includes: receiving the first state information when the battery system controller is in a working state.

This enables the power supply from the battery to the battery system controller to be disconnected when the vehicle is not in use, that is, when the battery system controller is not needed, thereby reducing the power consumption of the battery system controller.

According to a third aspect, an apparatus for controlling a battery is provided, including: a processing module, where the processing module is configured to perform the method according to any embodiment of the first aspect, or perform the method according to any embodiment of the second aspect.

According to a fourth aspect, an apparatus for controlling a battery is provided, including: a processor and a memory, where the memory stores an instruction, and when the instruction is run by the processor, the apparatus is enabled to perform the method according to any embodiment of the first aspect, or perform the method according to any embodiment of the second aspect.

According to a fifth aspect, a computer-readable storage medium is provided, where the computer-readable storage medium stores a computer program, and when the computer program is executed, the method according to any embodiment of the first aspect is performed, or the method according to any embodiment of the second aspect is performed.

### BRIEF DESCRIPTION OF DRAWINGS

To describe technical solutions in embodiments of the present application more clearly, the following briefly describes the accompanying drawings required for describing the embodiments of the present application. Apparently, the accompanying drawings in the following description show merely some embodiments of the present application, and persons of ordinary skill in the art may still derive other drawings from the accompanying drawings without creative efforts.
FIG. 1 is a schematic structural diagram of a vehicle according to embodiments of the present application.
FIG. 2 is a method for controlling a battery according to embodiments of the present application.
FIG. 3 is another method for controlling a battery according to embodiments of the present application.
FIG. 4 is another method for controlling a battery according to embodiments of the present application.
FIG. 5 is another method for controlling a battery according to embodiments of the present application.
FIG. 6 is another method for controlling a battery according to embodiments of the present application.
FIG. 7 is an apparatus for controlling a battery according to embodiments of the present application.
FIG. 8 is another apparatus for controlling a battery according to embodiments of the present application.
FIG. 9 is another apparatus for controlling a battery according to embodiments of the present application.

### DESCRIPTION OF EMBODIMENTS

The following further describes implementations of the present application in detail with reference to the accompanying drawings and embodiments. The following detailed description of embodiments and the accompanying drawings are intended to illustrate the principle of the present application rather than to limit the scope of the present application, that is, the present application is not limited to the embodiments as described.

In the description of the present application, it should be noted that, unless otherwise specified, the first, second, and various numerical references are merely used for differentiation for convenience of description and are not intended to limit the scope of the embodiments of the present application. "At least one" refers to one or more, and "a plurality of" refers to two or more. "And/or" describes an association relationship between associated objects, indicating that three relationships may exist. For example, A and/or B may represent the following cases: Only A exists, both A and B exist, and only B exists, where A and B may be singular or plural. The character "/" usually indicates an "or" relationship between the associated objects. "At least one of the following items (pieces)" or a similar expression thereof means any combination of these items, including a singular item (piece) or any combination of plural items (pieces). For example, at least one item (object) of a, b, and c may indicate: a, or b, or c, or a and b, or a and c, or b and c, or a, b, and c, where a, b, and c may each be singular or plural.

Unless otherwise defined, all technical and scientific terms used in the present application have the same meanings as commonly understood by those skilled in the technical field to which the present application belongs. The terms used in the specification of the present application are only for the purpose of describing specific embodiments and are not intended to limit the present application. The terms "include", "have", and any variations thereof in the specification and claims of the present application and the above description of the drawings are intended to cover non-exclusive inclusions.

Reference to "embodiment" in the present application means that specific features, structures, or characteristics described with reference to the embodiment may be included in at least one embodiment of the present application. The word "embodiment" appearing in various places in this specification does not necessarily refer to the same embodiment or an independent or alternative embodiment that is exclusive of other embodiments. Persons skilled in the art explicitly and implicitly understand that an embodiment described in the present application may combine with another embodiment.

In the embodiments of the present application, the battery cell may include a lithium-ion secondary battery, a lithium-ion primary battery, a lithium-sulfur battery, a sodium-lithium-ion battery, a sodium-ion battery, a lithium metal battery, a magnesium-ion battery, or the like, which is not limited in the embodiments of the present application. The battery cell may be cylindrical, flat, cuboid, or of other shapes, which is not limited in the embodiments of the present application either. Battery cells are typically divided into three types by packaging method: cylindrical cell, prismatic cell, and pouch cell, which is not limited in the embodiments of the present application either.

The battery mentioned in the embodiments of the present application is a single physical module that includes one or more battery cells for providing a higher voltage and capacity. For example, the battery mentioned in the present application may include a battery module, a battery pack, or the like. A battery typically includes an enclosure for packaging one or more battery cells. The enclosure may prevent liquids or other foreign objects from affecting the charging or discharging of the battery cells.

During the process in which the battery supplies electric energy to the vehicle, thermal runaway may occur in the battery, causing the temperature inside the battery to rise rapidly and affecting the driving safety of the vehicle. However, immediately disconnecting the battery supply circuit after thermal runaway occurs may cause the vehicle to lose power, which may also affect the driving safety of the vehicle.

In view of this, the present application provides a method for controlling a battery. According to the actual working state of the battery, when a fault occurs in the battery, the closed state and the open state of the battery are reasonably controlled, so that power may still be supplied to a vehicle to reduce the possibility of accidents caused by the vehicle due to sudden battery power failure. Moreover, the battery state of charge may be decreased to lower the risk of accidents, thereby improving the reliability of the battery in supplying electric energy to the vehicle and enhancing user experience.

The technical solutions described in the embodiments of the present application are all applicable to various electric devices using batteries. The electric device may be a vehicle, an energy storage device, a mobile phone, a portable device, a notebook computer, a ship, a spacecraft, an electric toy, an electric tool, or the like. The vehicle may be a two-wheeled vehicle, a fossil fuel vehicle, a natural-gas vehicle, or a new energy vehicle. The energy storage devices may be an uninterruptible power supply (uninterruptible power supply, UPS) for energy storage. The new energy vehicle may be a battery electric vehicle, a hybrid electric vehicle, a range-extended electric vehicle, or the like. The spacecraft includes an airplane, a rocket, a space shuttle, a spaceship, and the like. The electric toy includes a fixed or mobile electric toy, for example, a game console, an electric toy car, an electric toy ship, and an electric toy airplane. The electric tool includes an electric metal cutting tool, an electric grinding tool, an electric assembly tool, and an electric railway-specific tool, for example, an electric drill, an electric grinder, an electric wrench, an electric screwdriver, an electric hammer, an electric impact drill, a concrete vibrator, and an electric planer. Embodiments of the present application include, but are not limited to, the above electric devices.

For ease of description, the electric device being a vehicle is used as example for description of the following embodiments.

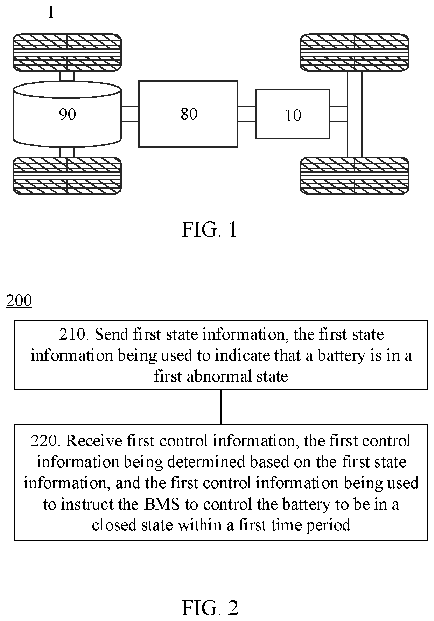

FIG. 1 is a schematic structural diagram of a vehicle 1 according to one embodiment of the present application. The vehicle 1 may be a fossil fuel vehicle, a natural-gas vehicle, or a new energy vehicle, where the new energy vehicle may be a battery electric vehicle, a hybrid electric vehicle, a range-extended vehicle, or the like. A motor 90, a controller 80, and a battery 10 may be provided inside the vehicle 1, where the controller 80 is configured to control the battery 10 to supply power to the motor 90. For example, the battery 10 may be disposed at the bottom, front, or rear of the vehicle 1. The battery 10 may be configured to supply power to the vehicle 1. For example, the battery 10 may be used as an operational power source for the vehicle 1 which is configured for a circuit system of the vehicle 1, for example, to satisfy power needs of start, navigation, and running of the vehicle 1. In another embodiment of the present application, the battery 10 may be used not only as the operational power source for the vehicle 1, but also as a driving power source for the vehicle 1, replacing or partially replacing fossil fuel or natural gas to provide driving traction for the vehicle 1.

In the embodiments of the present application, the battery 10 may include a battery management system (battery management system, BMS), and the controller 80 may include a battery system controller. The battery management system may be configured to collect parameters of the battery, and the battery system controller may generate a control strategy, so that the battery system controller may control the battery to be in a closed state or open state. Information interaction may be performed between the battery management system and the battery system controller to implement control of the battery. In a vehicle, the battery system controller may specifically be a vehicle controller area network (controller area network, CAN). Optionally, the battery system controller may be a vehicle control unit (vehicle control unit, VCU) on the vehicle that communicates with the battery management system. In some energy storage devices, the battery system controller may specifically be a control system of the energy storage device, that is, an energy management system (energy management system, EMS).

FIG. 2 shows a method 200 for controlling a battery, applied to a battery management system. Specifically, the method 200 may include at least the following steps.

210: Send first state information, where the first state information is configured to indicate that the battery is in a first abnormal state.

220: Receive first control information, where the first control information is determined based on the first state information and configured to instruct the BMS to control the battery to be in a closed state within a first time period.

During the process in which a battery in a normal state is supplying electric energy to a vehicle, various battery parameters of the battery are all within preset parameter ranges. When a fault has occurred or is about to occur in the battery, for example, when thermal runaway, electrolyte leakage, or another condition that may cause battery failure occurs inside the battery, at least one battery parameter in the battery may exceed a preset parameter range. In this case, the battery may be determined to be in a first abnormal state, and the first state information is information indicating that the battery is in the first abnormal state. The first state information may be configured to trigger the battery system controller to formulate a control strategy for the battery in the first abnormal state, to reduce the impact of the battery in the first abnormal state on the vehicle. Specifically, the first state information may be generated when the battery is in the first abnormal state, requesting the battery system controller for further control of the battery, to reduce the possibility of accidents.

In some embodiments, the BMS sends the first state information to the battery system controller, and the battery system controller determines the control strategy for the battery based on the first state information, that is, determines the first control information. The BMS receives the first control information from the battery system controller. Specifically, the first control information is configured to instruct the BMS to control the battery to be in a closed state within the first time period. Optionally, the BMS may further control the battery to be in a closed state within the first time period.

In some embodiments, the first state information may include information indicating that the battery is in the first abnormal state, and the battery system controller only needs to obtain the first state information to determine the first control information.

In some embodiments, the first state information may include specific information configured to determine that the battery is in the first abnormal state, for example, the relationship between a battery parameter and a corresponding preset range. The battery system controller may determine a specific control strategy in the first control information based on the first state information, for example, a length of the first time period and adjustment of the battery parameter.

The first time period may refer to a period of time immediately following the BMS receiving the first control information, or may refer to any period of time after the BMS receives the first control information. The battery system controller may flexibly set the start time of the first time period based on the first state information. The length of the first time period may also be flexibly set according to actual needs, for example, the first time period may be 5 to 10 minutes.

The battery being in a closed state refers to a state in which, even when a fault occurs, the battery may still enable a circuit to remain conductive and supply power to a vehicle. In some embodiments, the BMS may control closing or opening of a battery switch to respectively implement the closed state and open state of the battery. Optionally, the BMS may also implement control the closed state and open state of the battery by changing a current or a voltage of the battery.

In some embodiments, in determining the control strategy for the battery, the battery system controller may directly control the battery such that the battery is in a closed state within the first time period.

In the embodiments of the present application, the state of the battery may be classified into a closed state and an open state according to whether the battery supplies electric energy to the vehicle. The closed state of the battery refers to a state in which a circuit between the battery and the vehicle is connected, and the battery may supply power to the vehicle through the circuit. The open state of the battery refers to a state in which the circuit between the battery and the vehicle is disconnected, and the battery does not supply power to the vehicle. When the battery supplies electric energy to the vehicle the state of the battery may be classified into a normal state and an abnormal state, according to an operating condition of the battery. The normal state of the battery refers to a state of the battery in which a first parameter value of a battery parameter is within a first preset range; and the abnormal state of the battery refers to a state of the battery in which the first parameter value of the battery parameter exceeds the first preset range. In some embodiments, the abnormal state of the battery may include a first abnormal state and a second abnormal state. The first abnormal state refers to an abnormal state occurring before the battery is controlled. When receiving the first abnormal state, the battery system controller sends first control information to the BMS so that the battery is in the closed state within the first time period. The second abnormal state refers to a state in which the battery remains abnormal after the first time period. When receiving the second abnormal state, the battery system controller sends second control information to the BMS so that the battery is in an open state within a second time period.

In the embodiments of the present application, when the battery is in an abnormal state, the BMS may receive an instruction from the battery system controller and control the battery to be in the closed state for a certain period of time after a fault occurs in the battery, so as to supply power to the vehicle. This allows the vehicle to maintain sufficient power to stop, reducing the possibility of accidents caused by the vehicle losing power due to sudden battery power failure. Moreover, the BMS controlling the battery to continuously supply power to the vehicle facilitates continuous cooling of the battery by thermal management components, inhibits heat diffusion inside the battery, reduces the possibility of further damage to the battery, and allows the battery state of charge to decrease, facilitating subsequent maintenance or replacement of the battery. Continuous power supply from the battery to the vehicle may also extend the duration of acoustic, optical, and electrical alarms of the vehicle, providing assistance to the user. Overall, the embodiments of the present application may improve battery reliability, reduce the risk of severe accidents, and enhance the user experience.

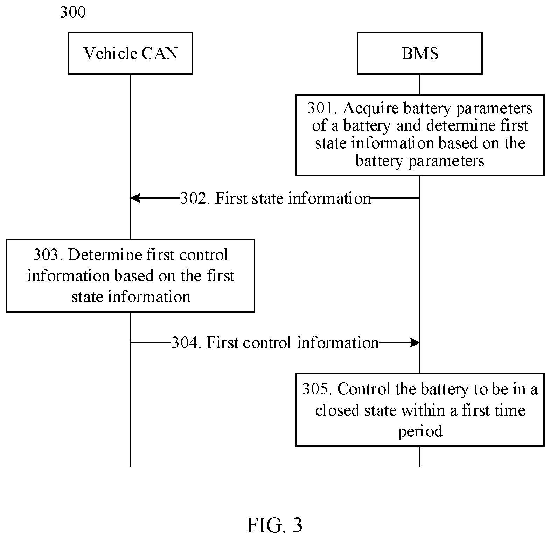

According to some embodiments of the present application, FIG. 3 shows a method 300 for controlling a battery. The battery system controller receives first state information sent by the BMS, and determines a control strategy for the battery based on the first state information. Specifically, the method 300 may include at least the following steps.

301: A BMS acquires battery parameters of the battery and determines the first state information based on the battery parameters.

Battery parameters may often directly reflect a state of the battery. The BMS may acquire the state of the battery more quickly and directly based on the battery parameters, which is beneficial for improving the speed and accuracy of acquiring the battery state.

A first parameter value of a battery parameter within a first preset range may indicate that the battery is in a normal state and may normally supply electric energy to the vehicle. For another example, the first parameter value of the battery parameter exceeding the first preset range may indicate that the battery is in a first abnormal state.

In some embodiments, the battery parameters may include at least one parameter among voltage, current, air pressure, temperature, and gas concentration of the battery. Specifically, when a parameter value of any of the above parameters exceeds a corresponding preset range, the battery may be considered to be in a first abnormal state. For example, when the voltage and the current are not within the corresponding preset ranges, it may indicate that a short circuit may have occurred or is about to occur inside the battery, or that other circuit faults may exist. When the air pressure and the gas concentration are not within the corresponding preset ranges, it may indicate that liquid leakage may have occurred inside the battery, or that the external environment may be in a situation affecting the normal operation of the battery. When the temperature is not within a corresponding preset range, it may indicate that thermal runaway may have occurred or is about to occur inside the battery. The above battery parameters are only exemplified as a specific manner of determining the first state information based on the battery parameters, and the battery parameters in the embodiments of the present application are not limited to the above parameters.

302: The BMS sends the first state information to the battery system controller.

When detecting that the battery is in the first abnormal state, the BMS sends the first state information to the battery system controller. The first state information may carry a field indicating that the battery is in the first abnormal state, so that when receiving the first state information, the battery system controller may acquire information indicating that the battery is in the first abnormal state.

In some embodiments, the battery system controller in a working state receives the first state information. When the battery system controller is in a non-working state, for example, in a standby state or shutdown state, the battery system controller needs to be woken up, that is, switched to a working state, and only then may the battery system controller receive the first state information, so as to determine the control strategy for the battery based on the first state information. This enables the power supply from the battery to the battery system controller to be disconnected when the vehicle is not in use, that is, when the battery system controller is not needed, thereby reducing the power consumption of the battery system controller.

303: The battery system controller determines the first control information based on the first state information.

Step 303 is the same as step 220 in method 200, and details are not repeated here.

304: The battery system controller sends the first control information to the BMS.

The first control information includes the control strategy for the battery. Specifically, the first control information may be configured to instruct the BMS to control the battery to be in a closed state within the first time period.

In some embodiments, when the battery system controller is in a working state, the battery system controller sends the first control information to the BMS. When the battery system controller is in a non-working state, for example, in a standby state or shutdown state, the battery system controller needs to be switched to a working state, and only then may the battery system controller send the first control information to the BMS to instruct the BMS to control the battery. This may reduce power consumption of the battery system controller when the vehicle is not in use.

305: The BMS controls the battery to be in a closed state within the first time period.

The first control information may carry a corresponding indication field, and the BMS, when receiving the first control information, may control the battery to be in a closed state within the first time period indicated in the first control information.

In some embodiments, the start time of the first time period is the same as a time at which the BMS receives the first control information. Specifically, after the BMS receives the first control information, the BMS immediately controls the battery to enter the first time period in the closed state, so as to continuously provide power to the vehicle. In some embodiments, the first control information may include a field indicating the duration of the first time period, and the BMS, in the case of receiving the first control information, controls the battery to be in a closed state within the duration range of the first time period. This enables the state of the battery to be controlled in a timely manner when an abnormality occurs in the battery, reducing the possibility of the battery being forcibly powered off in a first abnormal state and thereby reducing the possibility of accidents caused by the vehicle suddenly losing power.

In method 300, the battery being in a closed state within the first time period may supply power to the vehicle, enabling the vehicle to have sufficient power to travel to a suitable position to pull over when the battery is in the first abnormal state, thereby reducing the possibility of accidents caused by a sudden loss of power of the vehicle. The battery being in a closed state may also supply electric energy to thermal management components, enabling the thermal management components to perform cooling so as to cool the battery, thereby reducing a possibility of thermal runaway of the battery and slowing down a propagation speed of thermal runaway. In addition, the battery being in a closed state within the first time period may enable the battery to reduce the battery state of charge through discharge, reducing the risk of accidents caused by the battery.

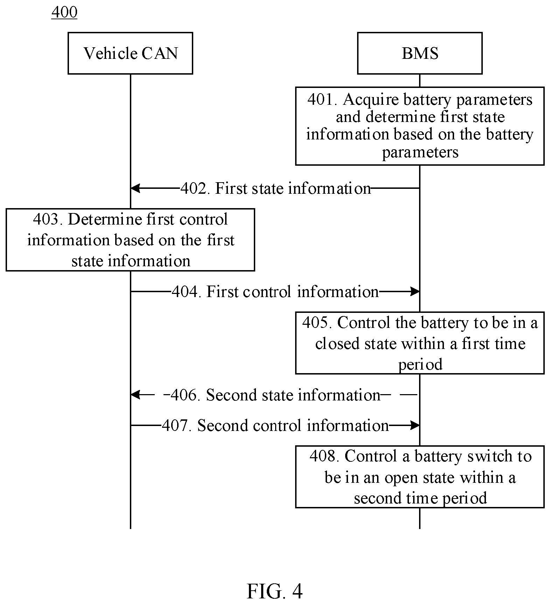

According to some embodiments of the present application, FIG. 4 shows another method 400 for controlling a battery. In method 400, the battery is in a closed state within a first time period, is opened at the end of the first time period, and is again in a closed state after an interval of a second time period. Specifically, the method 400 may at least include the following steps.

401: A BMS acquires battery parameters and determines the first state information based on the battery parameters, where the first state information is configured to indicate that a battery is in a first abnormal state.

402: The BMS sends the first state information to a battery system controller.

403: The battery system controller determines first control information based on the first state information, wherein the first control information is configured to instruct the BMS to control the battery to be in a closed state within a first time period.

404: The battery system controller sends the first control information to the BMS.

405: The BMS controls the battery to be in a closed state within the first time period.

Steps 401 to 405 are the same as steps 301 to 305 in method 300, and details are not repeated here.

Optionally, method 400 may include 406: The BMS sends second state information to the battery system controller, where the second state information is configured to indicate that the battery is in a second abnormal state after the end of the first time period.

The second abnormal state refers to a working state of the battery after the first time period. When the battery is in the second abnormal state, there still exists a significant risk of accidents caused by the battery, and further control of the battery is required to reduce this risk. In the embodiments of the present application, the second abnormal state may represent information that triggers the battery system controller to determine a further control strategy for the battery. Other battery states for triggering the battery system controller to determine further control strategies may be considered equivalent to the second abnormal state.

In some embodiments, whether the battery is in the second abnormal state may be determined by comparing the battery parameters with corresponding preset ranges. For example, when a second parameter value of a battery parameter exceeds a second preset range, the battery may be considered to be in the second abnormal state. The battery parameters may include at least one parameter among voltage, current, air pressure, temperature, and gas concentration of the battery. The second parameter value is a value of the battery parameter after the first time period.

When the battery is in the second abnormal state, the BMS sends the second state information to the battery system controller. The second state information may carry a field indicating that the battery is in the second abnormal state. When receiving the second state information, the battery system controller may acquire information indicating that the battery is in the second abnormal state.

The battery system controller, by acquiring the second state information of the battery, may determine the second control information based on the actual state of the battery. This allows more flexible and accurate control of the battery, facilitating rapid reduction of risks posed by the battery in an abnormal state and improves the reliability of the battery in supplying power to the vehicle.

407: The battery system controller sends second control information to the BMS, where the second control information is configured to instruct the BMS to control the battery to be in an open state within the second time period and to be closed at the end of the second time period, where a start time of the second time period is the same as an end time of the first time period.

The second time period refers to a time period immediately following the first time period. Specifically, the battery is in a closed state within the first time period, is opened at the end time of the first time period, is in an open state within the second time period, and is brought back to a closed state at the end of the second time period. A start time of the second time period and the end time of the first time period may correspond to a same moment.

The open state of the battery refers to a state in which the battery does not supply power to the vehicle. In some embodiments, a battery in an open state may indicate that the vehicle high-voltage control system is not in a working state, while the vehicle low-voltage control system may still be in a working state. The vehicle high-voltage control system generally uses the electric energy of the battery to control vehicle components such as thermal management components and motors, whereas the vehicle low-voltage control system generally uses the electric energy of the battery to power components such as the BMS and alarm elements.

When receiving a trigger signal, the battery system controller may send the second control information to the BMS, and the trigger signal may be configured to indicate a state of the battery or a state of the vehicle.

In some embodiments, the battery system controller may determine the second control information based on the second state information. Specifically, when receiving the second state information, the battery system controller may send the second control information to the BMS. The second control information is configured to control the battery after the first time period. The battery system controller may set a specific duration of the second time period as needed, for example, the second time period may be 5 to 10 minutes.

In other embodiments, the second control information may alternatively be determined based on the driving state of the vehicle. Specifically, the battery supplies power to the vehicle within the first time period, thereby allowing the vehicle to have sufficient time to travel to a suitable position to stop. Once the vehicle has pulled over and stopped safely, the first time period may end. In this case, when receiving a signal indicating that the vehicle is in a parked state, the battery system controller may send the second control information to instruct the BMS to control the battery to be in an open state within the second time period.

408: The BMS controls the battery to be in an open state within the second time period.

The second control information may carry a corresponding indication field, and when receiving the second control information, the BMS may control the battery to be in an open state within the second time period indicated in the second control information.

In some embodiments, the battery system controller may directly determine a discharge strategy for the battery in the first abnormal state based on the first state information. For example, when receiving the first state information, the battery system controller may send first preset control information to the BMS to instruct the BMS to control the battery to be in a closed state within the first time period, to be in an open state within the second time period, and to be in a closed state again at the end of the second time period. In this case, the first time period and the second time period may be preset values, where the preset values indicate durations of the corresponding time periods. For example, the first time period may be within 5 to 10 minutes, and the second time period may also be within 5 to 10 minutes. Optionally, the first preset control information may include a duration field of the first time period and a duration field of the second time period. When receiving the first preset control information, the BMS may sequentially control the battery to be in a closed state within the duration of the first time period and to be in an open state within the duration of the second time period based on to the duration fields in the first preset control information, starting from the time at which the first preset control information is received.

Optionally, the first preset control information may also include cyclic control of the battery state, that is, after the end of the second time period, the BMS may continue to control the battery to be in a closed state for the first time period, and cyclically execute the control strategy of the second time period and the first time period, until the battery state of charge is depleted, or a signal to stop the cycle is received, at which point the cycle stops.

In method 400, the battery being in a closed state within the first time period may supply power to the vehicle, allowing the vehicle to maintain sufficient power to travel to a suitable position to stop when the battery is in the first abnormal state, thereby reducing the possibility of accidents caused by the vehicle suddenly losing power. Moreover, discharging the battery reduces the battery state of charge, thereby reducing the risk of accidents caused by the battery. The battery being in an open state within the second time period enables timely disconnection of the electrical connection between the vehicle and the battery once the vehicle has stopped, thereby reducing the high-voltage risk caused by continuous energization. The method 400 may take both of the above effects into account, which is beneficial for improving the reliability of the battery in supplying electric energy to the vehicle.

In the case of cyclically controlling the closed state and open state of the battery, the battery may be discharged while in the closed state to reduce its state of charge, and the thermal management components may be controlled to cool to lower the temperature of the battery, thereby reducing the possibility of the battery causing more serious accidents; while the battery being in an open state may reduce the high-voltage risk of the battery, thereby reducing the risks caused by continuous discharge of the battery.

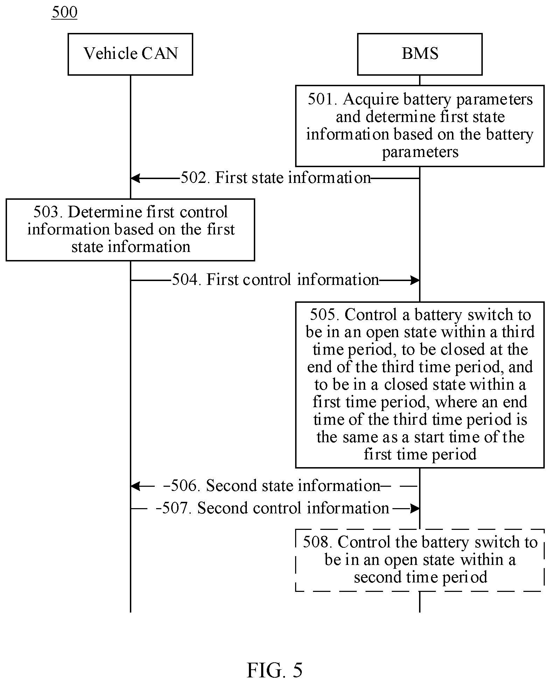

According to some embodiments of the present application, FIG. 5 shows another method 500 for controlling a battery. In method 500, when the battery is in the first abnormal state, the BMS may control the battery to be in different states sequentially within the third time period and the first time period. Specifically, the battery may be in an open state within the third time period, be in a closed state at the end of the third time period, and be in the closed state for the first time period. Specifically, method 500 may include at least the following steps.

501: A BMS acquires battery parameters and determines first state information based on the battery parameters, where the first state information is configured to indicate that the battery is in a first abnormal state.

502: The BMS sends the first state information to a battery system controller.

Steps 501 to 502 are the same as steps 301 to 302 in method 300, and details are not repeated here.

503: The battery system controller determines first control information based on the first state information, where the first control information is configured to instruct the battery to be in an open state within a third time period, to be closed at the end of the third time period, and to be in a closed state within a first time period, and an end time of the third time period is the same as a start time of the first time period.

In step 503, the first time period indicated in the first control information starts from a period of time after the BMS receives the first control information. Specifically, when receiving the first control information, immediately the BMS controls the battery to be in an open state and enters the third time period, and at the end of the third time period, controls the battery to be in a closed state and enters the first time period. That is, the first time period starts from the end time of the third time period. The end time of the third time period and the start time of the first time period may refer to a same moment.

In some embodiments, the third time period may be a time period immediately following the time at which the BMS receives the first control information. Optionally, the third time period may be a time period after a period of time following the time at which the BMS receives the first control information.

504: The battery system controller sends the first control information to the BMS.

505: The BMS controls the battery switch to be in an open state within the third time period, to be closed at the end of the third time period, and to be in a closed state within the first time period, where an end time of the third time period is the same as a start time of the first time period.

The first control information may carry a corresponding indication field, for example, it may carry a first field and a second field, where the first field is configured to instruct the battery to be in an open state within the third time period, and the second field is configured to instruct the battery to be in a closed state within the first time period. The first field may include a duration of the third time period, and the second field may include a duration of the first time period. Moreover, the first control information may instruct the BMS to execute the indication of the first field before executing the indication of the second field. When receiving the first control information, the BMS may control the open state and closed state of the battery according to the third time period and first time period indicated in the first control information.

Specifically, when receiving the first control information, the BMS may immediately control the battery to be in an open state, and to be in the open state for the third time period, to be in a closed state at the end of the third time period, and to be in the closed state for the first time period.

Optionally, method 500 may further include the following steps.

506: The BMS sends second state information to the battery system controller, where the second state information is configured to indicate that the battery is in a second abnormal state after the end of the first time period.

507: The battery system controller sends second control information to the BMS, where the second control information is configured to instruct the BMS to control the battery to be in an open state within a second time period and to be closed at the end of the second time period, and a start time of the second time period is the same as the end time of the first time period.

508: The BMS controls the battery to be in an open state within the second time period.

Steps 506 to 508 are the same as steps 406 to 408 in method 400, and details are not repeated here.

Considering that an abnormality occurring when the battery is in a closed state is prone to causing a high-voltage risk, in the method 500, the abnormal battery is controlled to immediately enter an open state, thereby reducing the possibility of high-voltage risk. Moreover, controlling the battery to return to the closed state after the third time period allows electric energy to be supplied to the vehicle in a timely manner, reducing the risk of accidents caused by the vehicle losing power and facilitating thermal management components in regulating the battery temperature.

In addition, cyclic control of closing and opening the battery may further cool and discharge the battery, reducing the possibility of accidents caused by the abnormal state of the battery.

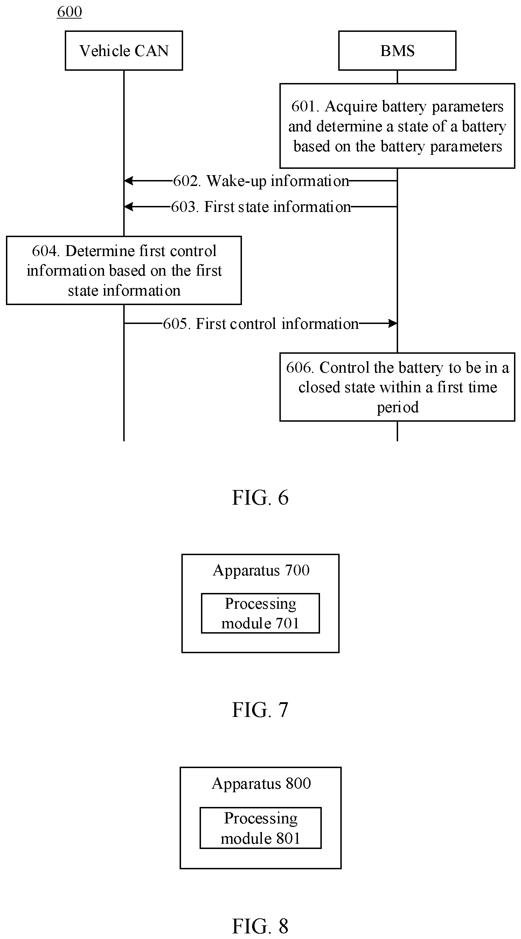

According to some embodiments of the present application, FIG. 6 shows another method 600 for controlling a battery. In method 600, the vehicle is in a parked state, and the battery system controller needs to be woken up by the BMS, then determines the control strategy for the battery based on the first state information sent by the BMS. Specifically, method 600 may include at least the following steps.

601: Acquire battery parameters and determine a state of a battery based on the battery parameters.

When the vehicle is in a parked state, the battery generally does not supply power to the vehicle high-voltage control system, and the battery system controller is in a non-working state, for example, the battery system controller may be in a standby state or a shutdown state. The battery may retain power supply to the vehicle low-voltage control system, and thus the BMS may still acquire the battery parameters of the battery, and determine whether the battery is in the first abnormal state based on the battery parameters.

602: The BMS sends wake-up information to the battery system controller, where the wake-up information is configured to instruct the battery system controller to switch from a non-working state to a working state.

When the BMS determines that the battery is in the first abnormal state, the BMS issues an alarm through an alarm element and sends the wake-up information to the battery system controller. The wake-up information is configured to switch the battery system controller from a non-working state to a working state, for example, switching from a standby state to a working state, so that the battery system controller may instruct the BMS to control the state of the battery. In some embodiments, the wake-up information may be sent when the battery system controller is in a non-working state.

603: The BMS sends the first state information to the battery system controller.

604: The battery system controller determines the first control information based on the first state information.

605: The battery system controller sends the first control information to the BMS.

606: The BMS controls the battery to be in a closed state within the first time period.

Steps 603 to 606 may be the same as steps 302 to 305 in method 300, or may be the same as steps 502 to 505 in method 500, and details are not repeated here. Optionally, method 600 may further include steps of cyclic control of the closed state and the open state of the battery, and the specific steps may be the same as steps 406 to 408 in method 400, or may be the same as steps 506 to 508 in method 500, and details are not repeated here.

When the vehicle is in a parked state, the BMS in the method 600 wakes up the battery system controller, so that abnormalities that have occurred or are about to occur in the battery may be controlled in a timely manner, thereby reducing adverse effects of the abnormal state of the battery on the vehicle and reducing the possibility of accidents caused by the battery in the abnormal state.

Embodiments of the present application further provide an apparatus 700 for controlling a battery, as shown in FIG. 7, including a processing module 701 configured to perform the steps performed by the battery system controller in the methods 200 to 600.

Embodiments of the present application further provide an apparatus 800 for controlling a battery, as shown in FIG. 8, including a processing module 801 configured to perform the steps performed by the BMS in the methods 200 to 600.

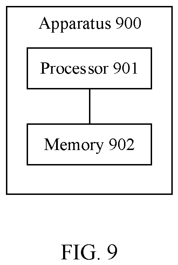

Embodiments of the present application further provide an apparatus 900 for controlling a battery, as shown in FIG. 9, including a processor 901 and a memory 902, where the memory 902 stores an instruction, and the instruction, when run by the processor 901, causes the apparatus 900 to perform any of the methods 200 to 600.

Embodiments of the present application further provide a computer-readable storage medium, where the computer-readable storage medium stores a computer program, and when the computer program is run, any of the methods 200 to 600 is performed.

Embodiments of the present application provide a method for controlling a battery. Specifically, during vehicle driving, a BMS acquires battery parameters, and determines whether a battery is in a first abnormal state based on the battery parameters. When the battery is in the first abnormal state, the BMS sends first state information to a battery system controller to indicate that the battery is in the first abnormal state. The battery system controller sends first control information to the BMS based on the first state information, and when receiving the first control information, the BMS controls the battery to be in a closed state.

Under a high-speed driving condition of the vehicle, this may reduce accidents caused by the vehicle suddenly losing power, and reduce the battery state of charge through discharging, reducing the risks brought by the abnormal battery.

Embodiments of the present application further provide a method for controlling a battery. Specifically, during vehicle driving, a BMS acquires battery parameters, and determines whether a battery is in a first abnormal state based on the battery parameters. When the battery is in the first abnormal state, the BMS sends first state information to a battery system controller to indicate that the battery is in the first abnormal state. The battery system controller sends first control information to the BMS based on the first state information, and when receiving the first control information, the BMS controls the battery to be in a closed state within the first time period. At the end of the first time period, the battery system controller sends second control information to the BMS, and when receiving the second control information, the BMS controls the battery to be in an open state within the second time period and to be in a closed state at the end of the second time period. Taking the battery being in a closed state for the first time period and being in an open state for the second time period as one cycle, cyclic control is performed on the battery until the battery temperature is less than a certain preset value or the battery state of charge is below a certain preset value.

Under a high-speed driving condition, this may reduce accidents caused by the vehicle suddenly losing power, and after the vehicle may be pulled over safely, the battery is controlled to be in an open state in a timely manner, reducing the high-voltage risk caused by continuous energization.

Embodiments of the present application further provide a method for controlling a battery. Specifically, during vehicle driving, a BMS acquires battery parameters, and determines whether a battery is in a first abnormal state based on the battery parameters. When the battery is in the first abnormal state, the BMS sends first state information to a battery system controller to indicate that the battery is in the first abnormal state. The battery system controller sends first control information to the BMS based on the first state information, and when receiving the first control information, the BMS controls the battery to be in an open state within the third time period, to be in a closed state at the end of the third time period, and to be in the closed state for the first time period.

In order to reduce the high-voltage risk caused by the abnormal battery being in a closed state, the battery is controlled to be in an open state within the third time period and to be in a closed state at the end of the third time period. The high-voltage risk brought by the abnormal battery may be reduced, and in addition, the losses caused by the vehicle losing power for a long time may also be reduced.

Embodiments of the present application further provide a method for controlling a battery. Specifically, when a vehicle is in a parked state, the battery does not supply power to the vehicle, and a BMS still monitors some basic parameters of the battery. When detecting that the battery is in a first abnormal state, the BMS sends wake-up information to a battery system controller, so that the battery system controller switches from a non-working state to a working state. When the battery system controller is in a working state, the BMS sends first state information to indicate that the battery is in the first abnormal state. The battery system controller sends a corresponding control strategy to the BMS based on the first state information, thereby improving the reliability of the battery in supplying power to the vehicle.

When the vehicle is in the parked state, this method may detect abnormalities of the battery in a timely manner and take corresponding measures in time, thereby reducing the possibility of accidents.

The above descriptions are only specific implementations of the present application, but are not intended to limit the protection scope of the present application. Any variation or replacement readily figured out by persons skilled in the art within the technical scope disclosed in the present application shall fall within the protection scope of the present application. Therefore, the protection scope of the present application shall be subject to the protection scope of the claims.

## Claims

1. A method for controlling a battery, **characterized in that** the method is applied to a battery management system and comprises:
sending first state information, wherein the first state information is configured to indicate that the battery is in a first abnormal state; and
receiving first control information, wherein the first control information is determined based on the first state information and configured to instruct a battery management system to control the battery to be in a closed state within a first time period.

2. The method according to claim 1, **characterized in that** the method further comprises:
receiving second control information, wherein the second control information is configured to instruct the battery management system to control the battery to be in an open state within a second time period and to be closed at the end of the second time period, wherein a start time of the second time period is the same as an end time of the first time period.

3. The method according to claim 2, **characterized in that** the method further comprises:
sending second state information of the battery, wherein the second state information is configured to indicate that the battery is in a second abnormal state after the end of the first time period.

4. The method according to any one of claims 1 to 3, **characterized in that**,
the first control information is further configured to instruct the battery to be in an open state within a third time period and to be closed at the end of the third time period, wherein an end time of the third time period is the same as a start time of the first time period.

5. The method according to any one of claims 1 to 3, **characterized in that**,
the start time of the first time period is the same as a time at which the battery management system receives the first control information.

6. The method according to any one of claims 1 to 3, **characterized in that** the receiving first control information comprises:
receiving the first control information when the battery is in the closed state.

7. The method according to any one of claims 1 to 3, **characterized in that** the method further comprises:
sending wake-up information when the battery is in an open state, wherein the wake-up information is configured to instruct a battery system controller to switch from a standby state to a working state.

8. The method according to claim 7, **characterized in that** the sending first state information comprises:
sending the first state information when the battery system controller is in a working state.

9. The method according to any one of claims 1 to 3, **characterized in that** the method further comprises:
acquiring battery parameters of the battery; and
determining the first state information based on the battery parameters.

10. The method according to claim 9, **characterized in that**,
the battery parameters comprise at least one parameter among voltage, current, air pressure, temperature, and gas concentration of the battery.

11. A method for controlling a battery, **characterized in that** the method is applied to a battery system controller and comprises:
acquiring first state information, wherein the first state information is configured to indicate that the battery is in a first abnormal state; and
determining first control information based on the first state information, wherein the first control information is configured to instruct a battery management system to control the battery to be in a closed state within a first time period.

12. The method according to claim 11, **characterized in that** the method further comprises:
sending second control information, wherein the second control information is configured to instruct the battery management system to control the battery to be in an open state within a second time period and to be closed at the end of the second time period, wherein a start time of the second time period is the same as an end time of the first time period.

13. The method according to claim 12, **characterized in that** the sending second control information comprises:
acquiring second state information of the battery, wherein the second state information is configured to indicate that the battery is in a second abnormal state after the end of the first time period; and
sending the second control information based on the second state information.

14. The method according to any one of claims 11 to 13, **characterized in that**, the first control information is further configured to instruct the battery to be in an open state within a third time period and to be closed at the end of the third time period, wherein an end time of the third time period is the same as a start time of the first time period.

15. The method according to any one of claims 11 to 13, **characterized in that**,
a start time of the first time period is the same as a time at which the battery management system receives the first control information.

16. The method according to any one of claims 11 to 13, **characterized in that** the method further comprises:
sending the first control information when the battery system controller is in a working state.

17. The method according to any one of claims 11 to 13, **characterized in that** the method further comprises:
receiving wake-up information, wherein the wake-up information is configured to instruct the battery system controller to switch from a non-working state to a working state.

18. The method according to any one of claims 11 to 13, **characterized in that** the acquiring first state information comprises:
receiving the first state information when the battery system controller is in a working state.

19. An apparatus for controlling a battery, **characterized by** comprising:
a processing module, the processing module being configured to perform the method according to any one of claims 1 to 10, or perform the method according to any one of claims 11 to 18.

20. An apparatus for controlling a battery, **characterized by** comprising:
a processor and a memory, wherein the memory stores an instruction, and when the instruction is run by the processor, the apparatus is enabled to perform the method according to any one of claims 1 to 10, or perform the method according to any one of claims 11 to 18.

21. A computer-readable storage medium, **characterized in that** the computer-readable storage medium stores a computer program, and when the computer program is executed, the method according to any one of claims 1 to 10 is performed, or the method according to any one of claims 11 to 18 is performed.
